Europäisches Patentamt

European Patent Office

Office européen des brevets

(19)

(11) Veröffentlichungsnummer: **0 134 469**
**B1**

# EUROPÄISCHE PATENTSCHRIFT

(12)

(45) Veröffentlichungstag der Patentschrift:
04.02.87

(51) Int. Cl.⁴: **H 01 L 21/268,** B 23 K 26/00

(21) Anmeldenummer: **84107743.1**

(22) Anmeldetag: **04.07.84**

(54) Verfahren zur Kennzeichnung von Halbleiteroberflächen durch Laserstrahlung.

(30) Priorität: **07.07.83 DE 3324551**

(43) Veröffentlichungstag der Anmeldung:
**20.03.85 Patentblatt 85/12**

(45) Bekanntmachung des Hinweises auf die Patenterteilung:
**04.02.87 Patentblatt 87/6**

(84) Benannte Vertragsstaaten:
**DE FR IT**

(56) Entgegenhaltungen:
**DE-B-1 765 400**

**APPLIED PHYSICS LETTERS, Band 34, Nr. 12, Juni 1979, New York, USA; P.L. LIU et al.:"Picosecond laser-induced melting and resolidification morphology on Si", Seiten 864-866**

(73) Patentinhaber: **Wacker- Chemitronic Gesellschaft für Elektronik- Grundstoffe mbH, Johannes- Hess- Strasse 24, D-8263 Burghausen (DE)**

(72) Erfinder: **Kuhn- Kuhnenfeld, Franz, Dr. Dipl.- Phys., Alte Poststrasse 19, D-8261 Emmerting (DE)**
Erfinder: **Kramler, Josef, Weidenweg 1, D-8269 Burgkirchen (DE)**
Erfinder: **Gerber, Hans- Adolf, Haeckerstrasse 10, D-8263 Burghausen (DE)**

EP 0 134 469 B1

## Beschreibung

Die Erfindung betrifft ein Verfahren zur Kennzeichnung von Halbleiteroberflächen durch Flächenmotive, welche jeweils durch Aufschmelzen und partielles Verdampfen eines Oberflächenausschnittes vermittels eines Laserpulses erzeugt werden.

Es ist bekannt, mit Hilfe von Laserstrahlung Halbleiteroberflächen zur Kennzeichnung mit Flächenmotiven zu versehen, aus deren Anordnung zueinander sich die gewünschten Symbole, wie Buchstaben oder Ziffern, ergeben. Solche Kennzeichnungen sollen kontrastreich und dauerhaft sein, d.h. beispielsweise auch nach mehreren Hochtemperatur- und/oder Oxidationsbehandlungen der jeweiligen Halbleiteroberfläche ohne Beeinträchtigung der Oberflächenqualität einwandfrei erkennbar sein.

Nach einem bekannten Verfahren werden auf die zu kennzeichnende Stelle der Halbleiteroberfläche starke Laserpulse eingestrahlt, die jeweils auf dem bestrahlten Oberflächenausschnitt das Halbleitermaterial zunächst zum Aufschmelzen und die Schmelze dann nahezu vollständig zum Verdampfen bringen. Auf diese Art werden als Flächenmotive punktförmige Vertiefungen erhalten, die an sich kontrastreich und dauerhaft, aber stets von einen Rand von Schmelzperlen und ungeordneten Verwerfungen (sogenanntem "slag") umgeben sind. Bei nachfolgenden Prozessen, z.B. Oxidationen, kann es in diesem "slag" bisweilen zu Ausbrüchen von kleinsten Partikeln kommen die sich dann auf der Oberfläche ablagern und letztlich zu Fehlern in den erhaltenen Bauelementen und damit zu Ausbeuteeinbußen führen können.

Dieser Nachteil wird durch ein anderes bekanntes Verfahren vermieden, bei welchem in den durch den Laserpuls bestrahlten Oberflächenausschnitt das Halbleitermaterial nur noch aufgeschmolzen und nicht mehr verdampft wird. Die solcherart erhaltenen punktförmigen Flächenmotive sind zwar slagfrei, aber kontrastarm und, wegen ihrer geringen Tiefe, wenig dauerhaft.

Ein weiteres Verfahren, bei dem mit Hilfe von Masken mit jeweils einem einzigen Laserpuls vollständige Buchstaben oder Ziffern in der Halbleiteroberfläche erzeugt werden, liefert nur eine ungleichmäßige und kontrastarme Beschriftung.

Die Aufgabe der Erfindung bestand also darin, ein Verfahren anzugeben, das eine Kennzeichnung von Halbleiteroberflächen durch kontrastreiche, dauerhafte und slagfreie, mittels Laserpulsen erzeugte Flächenmotive ermöglicht.

Gelöst wird die Aufgabe durch ein Verfahren, welches dadurch gekennzeichnet ist, daß der Laserpuls auf einen Oberflächenausschnitt eingestrahlt wird, dessen Fläche der 1,5- bis 6,5-fachen Fläche des Flächenmotives entspricht und daß die Energie des Laserpulses so eingestellt wird, daß nur im Zentrum dieses Oberflächenausschnittes auf einer dem Flächenmotiv entsprechenden Fläche das Halbleitermaterial aufgeschmolzen und partiell verdampft wird.

Nach diesem Verfahren lassen sich die Oberflächen von ein- oder mehrkomponentigem Halbleitermaterial kennzeichnen, wie beispielsweise Germanium, Galliumarsenid, Galliumphosphid, Indiumphosphid oder insbesondere Silicium.

Da das erfindungsgemäße Verfahren es gestattet, Flächenmotive mit hoher Präzision gleichmäßig und ohne Beeinträchtigung der Oberflächenqualität auf der Oberfläche zu erzeugen eignet es sich insbesondere für solche Oberflächen, die bereits sorgfältig vorbehandelt und daher qualitativ hochwertig sind. Es kommt somit in erster Linie für polierte Oberflächen in Frage, daneben aber auch für auf andere Art vorbehandelte Oberflächen mit einem niedrigen Mittenrauhwert $R_a$ (gemäß DIN 4769) von weniger als 0,4 µm, insbesondere für sauer geätzte Halbleiteroberflächen.

Besonders günstig lassen sich nach dem erfindungsgemäßen Verfahren kreisförmige Flächenmotive mit einem Durchmesser von 50 bis 150 µm in den Halbleiteroberflächen erzeugen, wie sie vom "Semiconductor Equipment and Materials Institute" (SEMI) als Grundelemente für die alphanumerische Kennzeichnung von Siliciumscheiben mit 100 mm und 125 mm Durchmesser vorgeschlagen und empfohlen werden. Mit diesen punktförmigen Grundelementen werden die Scheibenoberflächen gemäß dem SEMI-Standard in genau festgelegter Anordnung markiert, so daß sich die gewünschte Kennzeichnung durch Buchstaben, Ziffern oder andere Symbole ergibt.

Die Form der Flächenmotive wird hauptsächlich durch das jeweilige Schwingungsmuster des Lasers bestimmt. Die bevorzugten kreisförmigen Flächenmotive werden beispielsweise erzeugt, wenn der Laser in Grundmode ($TEM_{00}$) betrieben wird. Grundsätzlich ist auch ein Betrieb in anderen, niedrigindizierten transversalen Schwingungszuständen (Low index transversal mode) möglich, wenngleich die daraus resultierenden, z. B. elliptischen, Flächenmotive für die Kennzeichnung von Halbleiterscheiben von geringer Bedeutung sind. Daher wird im folgenden aus Gründen der Übersichtlichkeit lediglich das Verfahren für die Erzeugung von kreisförmigen Flächenmotiven dargelegt; es läßt sich jedoch sinngemäß auch auf anders geformte Flächenmotive übertragen.

Für die Durchführung des erfindungsgemäßen Verfahrens eignen sich solche Geräte, bei denen entweder der Durchmesser oder die Pulsenergie des Laserstrahls, oder besonders günstig beide Größen verstellbar sind, und zwar bevorzugt stufenlos. Günstig ist auch die Verwendung von Geräten mit Linsen langer Brennweite zwischen 300 und 1000 mm, die die Bestrahlung relativ großflächiger Oberflächenausschnitte gestatten.

Selbstverständlich gilt für die Auswahl der jeweiligen Strahlungsquelle, daß sie Licht geeigneter, also von dem zu kennzeichnenden Halbleitermaterial absorbierbarer Wellenlänge emittieren muß. Dementsprechend kommen für Siliciumoberflächen zweckmäßig Rubin- oder insbesondere Nd:YAG-Laser in Frage, welche vorzugsweise gütegeschaltet sind.

Die für die Kennzeichnung geeignete Einstellung der Laserpulsenergie und des Durchmessers des Laserstrahles wird zweckmäßig in Vorversuchen nach Maßgabe der gewünschten Fläche des, z.B. kreisförmigen, Flächenmotives ermittelt. Zu diesem Zweck wird im allgemeinen zunächst der Strahldurchmesser so eingestellt, daß auf der gewählten Halbleiteroberfläche, z.B. einer polierten Siliciumscheibe, ein Oberflächenausschnitt bestrahlt wird, dessen Fläche der 1,5-bis 6,5-fachen Fläche des Flächenmotives entspricht. Unter diesem bestrahlten Oberflächenausschnitt ist derjenige Teil der Oberfläche zu verstehen, auf den die Strahlung noch mit mindestens dem $I/e^2$-fachen Wert (e = Euler'sche Zahl) der maximalen Energiedichte (entsprechend etwa 13,5 % davon) auftrifft. In der Regel wird man bei einem kleinen Flächenmotiv, etwa einem Kreis mit 50 µm Durchmesser, einen einem größeren Vielfachen, meist der 4- bis 6,5-fachen Fläche entsprechenden Oberflächenausschnitt bestrahlen, während bei einem großen Flächenmotiv mit beispielsweise über 150 µm Durchmesser bereits die Bestrahlung eines nur 1,5- bis 3,5-fach größeren Oberflächenausschnittes gute Ergebnisse erbringt. Dabei kann mit defokussiertem oder bevorzugt mit fokussiertem Stahl gearbeitet werden.

Nachdem auf diese Weise der bestrahlte Oberflächenausschnitt festgelegt oder, bei Geräten ohne entsprechende Einstellmöglichkeit, vorgegeben ist, wird die Energiedichte des jeweils eingestrahlten Laserpulses so reguliert, daß nur im Zentrum dieses Oberflächenausschnittes auf einer dem gewünschten Flächenmotiv entsprechenden Fläche das Halbleitermaterial aufgeschmolzen und partiell verdampft wird. Dabei hat es sich als günstig erwiesen die Energiedichte, von einem Maximalwert ausgehend, allmählich auf einen geeigneten Wert zu reduzieren. In der Regel wird man dann weitere Feineinstellungen des Strahldurchmessers und der Pulsenergie vornehmen, bis genau das gewünschte Flächenmotiv erreicht ist. Auch bei Geräten mit vorgegebener Energiedichte kann durch Variation des Strahldurchmessers meist eine entsprechende Abstimmung der Parameter gefunden werden.

Die jeweils ermittelte Einstellung kann dann, im allgemeinen auch bei großen Stückzahlen, während des gesamten Kennzeichnungsvorganges beibehalten werden, bei dem in üblicher Weise mittels des z.B. durch Galvanometerspiegel auslenkbaren Laserstrahls Halbleiterscheiben in der Oberfläche mit Symbolen versehen werden.

Da es lediglich erforderlich ist, an der jeweils ausgewählten Stelle das Halbleitermaterial hauptsächlich aufzuschmelzen und nur in geringem Maße zu verdampfen, ist auch die Gefahr von Verunreinigungen, sei es der Oberfläche selbst, oder benachbarter Oberflächen durch abgedampfte Partikel gering.

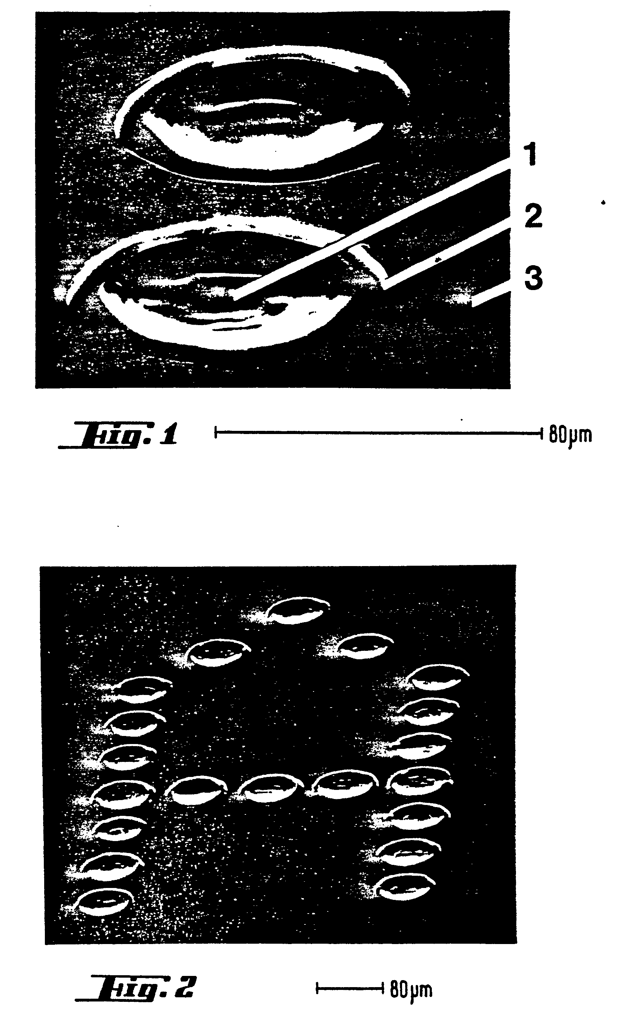

In den Figuren 1 und 2 sind zur weiteren Verdeutlichung Oberflächen von polierten Siliciumscheiben dargestellt, die nach dem erfindungsgemäßen Verfahren behandelt sind.

Figur 1 (Vergrößerung 1000-fach, Aufnahmewinkel 65°) zeigt die typische Form der erhaltenen kreisförmigen Flächenmotive. Diese weisen im Zentrum einen tellerartigen, gegenüber der ursprünglichen Oberfläche abgesenkten, im allgemeinen µm 1 bis 5 µm tiefer liegenden Bereich 1 auf. Dessen Tiefe läßt sich beispielsweise durch die Energiedichteverteilung des eingestrahlten Laserpulses steuern, und zwar wächst sie bei einer Erhöhung der Energiedichte im Zentrum des Pulses.

Nach außen hin steigt der abgesenkte Bereich allmählich an und geht schließlich in den ringförmigen Wulst 2 über, der gegenüber der ursprünglichen Oberfläche erhöht ist und die Begrenzung des Flächenmotives darstellt. Dieser Wulst bildet sich aus aufgeschmolzenem Material, das aus dem Inneren des Flächenmotives nach außen gedrängt wird. Dementsprechend ist er in der Regel um so höher, je tiefer das Zentrum abgesenkt ist. Im allgemeinen wird man eine Wulsthöhe von höchstens etwa 1 µm anstreben, um z. B. Störungen bei der Photolithographie nach dem Kontaktverfahren zu vermeiden.

Ein typisches Merkmal von nach dem erfindungsgemäßen Verfahren gekennzeichneten Halbleiteroberflächen ist der äußerst feine Ring 3, der das eigentliche Flächenmotiv, bestehend aus abgesenktem Bereich 1 und Wulst 2, in geringem Abstand umgibt.

In Fig. 2 (Vergrößerung 200-fach Aufnahmewinkel 65°) sind die kreisförmigen Flächenmotive beispielhaft zu dem Buchstaben "A" angeordnet; sie zeigt insbesondere, wie gleichmäßig und kontinuierlich sich die Flächenmotive auf eine Halbleiteroberfläche aufbringen lassen.

Die nach dem erfindungsgemäßen Verfahren erzeugten Flächenmotive sind besonders kontrastreich, da sie gegenüber der umgebenden Oberfläche sowohl gleichmäßig erhöhte als auch abgesenkte Bereiche besitzen. Darüber hinaus weisen sie auch die für eine hohe Dauerhaftigkeit ausreichende Tiefe auf und sind frei von Schmelzperlen, Verwerfungen, Kratern oder ähnlichen Oberflächenzerstörungen.

**Beispiel 1**

Polierte Siliciumscheiben (Durchmesser 100 mm, (111)-Orientierung) sollten mit kreisförmigen Flächenmotiven von ca. 75 µm Durchmesser, ca. 2 µm Tiefe und ca. 1 µm Wulsthöhe gekennzeichnet werden.

Es wurde ein gütegeschalteter Nd: YAG-Laser (Wellenlänge 1,06 µm, Dauerstrich-Nennleistung 12 Watt in $TEM_{00}$-Mode) verwendet, der Pulse mit einer Halbwertdauer von ca. 150 ns in einer Wiederholfrequenz von 1 kHz erzeugte. Der Strahl wurde am Laserausgang mit einem 6-fach-Teleskop auf einen Durchmesser von 5 mm aufgeweitet, wobei nur der Anteil des Strahles berücksichtigt ist, bei dem der $l/e^2$-fache Wert der maximalen Energiedichte überschritten wird.

Nun wurde eine Testscheibe zur Ermittlung der geeigneten Parameter in die am Gerät vorhandene Haltevorrichtung eingelegt.

Mit Hilfe einer Linse mit 500 mm Brennweite wurde der Laserstrahl nun auf einen Durchmesser von 155 µm auf die Scheibenoberfläche fokussiert. Der bestrahlte Oberflächenausschnitt entsprach damit etwa der 4,3-fachen Fläche des gewünschten Flächenmotives.

Anschließend wurde die Pulsenergie von ihrem Maximalwert 1,8 mJ mittels eines Abschwächers stufenlos reduziert, bis der aufgeschmolzene und partiell verdampfte Bereich im Zentrum des Oberflächenausschnittes die angestrebten Dimensionen erreicht hatte. Dies war bei 0,96 mJ der Fall.

Mit den so ermittelten Einstellwerten wurden sodann 100 polierte Siliciumscheiben nach einer gebräuchlichen Methode (Strahlablenkung durch zwei Galvanometerspiegel, Rechnersteuerung, variable Wiederholfrequenz) beschriftet.

Auf den erhaltenen Scheiben wurden stichprobenartig die Flächenmotive vermessen. Die gefundenen Durchmesser lagen bei 75 ± 5 µm, die Wulsthohen bei 1,0 ± 0,3 µm und die Tiefem bei 1,8 ± 0,5 µm. Alle Scheiben waren slagfrei.

Zehn dieser Scheiben wurden anschließend je sechsmal einer zweistündigen Oxidation in feuchtem Sauerstoff bei 1100°C unterzogen, und anschließend das gebildete Oxid mit Flußsäure abgeätzt. Danach war die Schrift noch einwandfrei lesbar, und es konnten keine Ausbrüche festgestellt werden.

**Beispiel 2**

In der Beispiel 1 entsprechenden Anordnung wurden 10 polierte Germaniumscheiben (Durchmesser 50 mm (100)-Orientie-rung) beschriftet. Der Durchmesser des Laserstrahls betrug 155 µm, die Pulsenergie 0,46 mJ.

In der Scheibenoberfläche wurden kreisförmige Flächenelemente mit Durchmesser 70 ± 5 µm, Wulsthöhe 0,9 ± 0,3 µm und Tiefe 1,7 ± 0,5 µm erhalten. Die Schriftpunkte waren gleichmäßig ausgebildet und völlig slagfrei.

**Patentansprüche**

1. Verfahren zur Kennzeichnung von Halbleiteroberflächen durch Flächenmotive, welche jeweils durch Aufschmelzen und partielles Verdampfen eines Oberflächenausschnittes vermittels eines Laserpulses erzeugt werden, dadurch gekennzeichnet, daß der Laserpuls auf einen Oberflächenausschnitt eingestrahlt wird, dessen Fläche der 1,5- bis 6,5-fachen Fläche des Flächenmotives entspricht, und daß die Energie des Laserpulses so eingestrahlt wird, daß nur im Zentrum dieses Oberflächenausschnittes auf einer dem Flächenmotiv entsprechenden Fläche das Halbleitermaterial aufgeschmolzen und partiell verdampft wird.

2. Verfahren nach Anspruch 1, dadurch gekennzeichnet, daß polierte oder sauer geätzte Halbleiteroberflächen mit einem Mittenrauhwert (nach DIN 4768) von höchstens 0,4 µm ausgewählt werden.

3. Verfahren nach Anspruch 1 und 2, dadurch gekennzeichnet, daß als Flächenmotiv kreisförmige Vertiefungen mit einem Durchmesser von 50 bis 150 µm erzeugt werden.

4. Verfahren nach den Ansprüchen 1 bis 3, dadurch gekennzeichnet, daß das Halbleitermaterial bis zu einer Tiefe von 1 bis 5 µm aufgeschmolzen und partiell verdampft wird.

**Claims**

1. Process for the marking of semiconductor surfaces by surface motifs, which are in each case produced by fusion and partial evaporation of a surface segment by means of a laser pulse, characterized in that the laser pulse is made to irradiate onto a surface segment, the area of which corresponds to 1.5 to 6.5 times the area of the surface motif, and in that the energy of the laser pulse is made to irradiate in such a way that the semiconductor material is fused and partially evaporated only in the centre of this surface segment on an area corresponding to the surface motif.

2. Process according to Claim 1, characterized in that polished or cleanly etched semiconductor surfaces with an average roughness (in accordance with DIN 4768) of at most 0.4 µm are selected.

3. Process according to Claims 1 and 2, characterized in that circular depressions with a diameter of 50 to 150 µm are produced as surface motif.

4. Process according to Claims 1 to 3, characterized in that the semiconductor material is fused and partially evaporated to a depth of 1 to 5 µm.

## Revendications

1. Procédé pour marquer des surfaces de semiconducteurs par des motifs superficiels créés par fusion et évaporation partielle d'une zone superficielle au moyen d'une impulsion laser, procédé caractérisé en ce qu'on envoie l'impulsion laser sur une zone superficielle dont la surface représente de 1,5 à 6,5 fois celle du motif superficiel, et en ce que l'énergie de l'impulsion laser est telle que la matière du semiconducteur ne soit fondue et partiellement évaporée qu'au centre de cette zone superficielle sur une surface correspondant au motif superficiel.

2. Procédé selon la revendication 1 caractérisé en ce qu'on prend des surfaces semiconductrices polies ou attaquées par un acide et dont la rugosité moyenne arithmétique (selon DIN 4 768) est d'au plus 0,4 µm.

3. Procédé selon l'une des revendications 1 et 2, caractérisé en ce qu'on crée, comme motifs superficiels, des creux circulaires d'un diamètre de 50 à 150 µm.

4. Procédé selon l'une quelconque des revendications 1 à 3, caractérisé en ce que la matière semiconductrice est fondue et partiellement évaporée jusqu'à une profondeur de 1 à 5 µm.

**Fig. 1** ⊢————————————⊣ 80 µm

**Fig. 2** ⊢————⊣ 80 µm